# EUROPEAN PATENT APPLICATION

(11) **EP 4 636 739 A1**
(43) Date of publication of application: **22.10.2025**
(21) Application number: 23920125.4
(22) Date of filing: 24.11.2023
(51) Int. Cl.: G09F 9/302, G09F 9/33, H05K 5/00, H05K 9/00

(54) **DISPLAY APPARATUS**

(30) Priority: 01.02.2023 KR 20230013939
(71) Applicant: Samsung Electronics Co., Ltd., Suwon-si, Gyeonggi-do 16677 (KR)
(72) Inventor: KIM, Dowan, Suwon-si Gyeonggi-do 16677 (KR); KIM, Kiwoong, Suwon-si Gyeonggi-do 16677 (KR); KIM, Yoonah, Suwon-si Gyeonggi-do 16677 (KR); PARK, Chiun, Suwon-si Gyeonggi-do 16677 (KR); JEON, Jinhyeong, Suwon-si Gyeonggi-do 16677 (KR); HWANG, Kwangsung, Suwon-si Gyeonggi-do 16677 (KR)
(74) Representative: Appleyard Lees IP LLP
(86) International application number: PCT/KR2023/019051
(87) International publication number: WO 2024/162576

(57) **Abstract**

This display apparatus may comprise: a cabinet; a substrate which is coupled to the cabinet and to which an LED is mounted; a reinforcing member disposed between the substrate and the cabinet and coupled to the substrate; a magnet disposed between the reinforcing member and the cabinet so that the substrate is coupled to the cabinet by the magnetic attraction between the reinforcing member and the cabinet; and a grounding member disposed between the substrate and the reinforcing member. Electromagnetic noise generated from the substrate on which the LED is mounted can be discharged via the substrate, the grounding member, the reinforcing member, the magnet, and the cabinet.

## Description

### [TECHNICAL FIELD]

The present disclosure relates to a display apparatus including a grounding member.

### [BACKGROUND ART]

A display apparatus is a type of output device that converts acquired or stored electrical information into visual information and displays it to a user.

The display apparatus may include a plurality of display modules and a cabinet that supports the plurality of display modules by tiling the plurality of display modules continuously in up, down, left, and right directions to implement a large-sized screen. A plurality of cabinets for supporting the plurality of display modules may be provided, and the plurality of cabinets may also be provided to be tileable continuously in the up, down, left, and right directions, similarly to the plurality of display modules. The plurality of display modules supported by the plurality of cabinets may form one large-sized screen.

The display apparatus may generate electromagnetic waves, as the display apparatus includes various electronic components such as LEDs, connectors, and circuit boards. Such electromagnetic waves may act as noise and may affect other electronic components within the display apparatus or other electronic devices. The electromagnetic noise may be referred to as electromagnetic interference (EMI), and it is necessary to stably emit the electromagnetic noise from the display apparatus.

### [DISCLOSURE]

### [TECHNICAL PROBLEM]

An embodiment of the present disclosure provides a display apparatus capable of stably emitting electromagnetic noise through a path provided in the display apparatus.

An embodiment of the present disclosure provides a display apparatus that is capable of allowing electromagnetic noise to be emitted through a simple structure, and also implements small-scale waterproofing.

Technical problems to be solved by the present disclosure are not limited to the above-mentioned technical problems, and other technical problems, which are not mentioned above, may be clearly understood from the following descriptions by those skilled in the art to which the present disclosure pertains.

A display apparatus according to an embodiment may include a cabinet, a substrate coupled to the cabinet and including light-emitting diodes (LEDs) mounted thereon, a reinforcing member disposed between the substrate and the cabinet and coupled to the substrate, a magnet disposed between the reinforcing member and the cabinet, such that the substrate is coupled to the cabinet by magnetic attraction between the reinforcing member and the cabinet, and a grounding member disposed between the substrate and the reinforcing member. The grounding member is provided such that electromagnetic noise generated from the substrate on which the LED is mounted may be discharged via the substrate, the grounding member, the reinforcing member, the magnet, and the cabinet.

A display apparatus according to an embodiment may include a cabinet, a substrate coupled to the cabinet and including an LED mounted thereon, a circuit case coupled to the cabinet and forming a circuit connector hole, a circuit connector disposed in the circuit connector hole of the circuit case to transmit signals to the substrate in which the LED is mounted, and a ground rib protruding toward the substrate from an inner surface of the circuit case forming the circuit connector hole. The ground rib may be provided such that electromagnetic noise generated from the substrate on which the LED is mounted and from the circuit connector may be discharged via the ground rib, the circuit case, and the cabinet.

In an display apparatus according to an embodiment including a cabinet and a display module coupled to the cabinet, the display module may include a substrate including an LED mounted thereon, a holder disposed at a rear side of the substrate to cover the substrate and including a ground hole, a reinforcing member disposed at a rear side of the holder, and a grounding member disposed at a rear side of the substrate to contact the reinforcing member and passing through the ground hole. The grounding member may be provided such that electromagnetic noise generated from the substrate on which the LED is mounted may be discharged via the grounding member, the reinforcing member, and the cabinet.

### [DESCRIPTION OF DRAWINGS]

FIG. 1 is a perspective view of a display apparatus according to an embodiment of the present disclosure.
FIG. 2 is an exploded perspective view of a display in the display apparatus according to an embodiment of the present disclosure.
FIG. 3 is a partially enlarged view of the display apparatus of FIG. 2.
FIG. 4 is a rear exploded perspective view of a display in the display apparatus according to an embodiment of the present disclosure.
FIG. 5 is a rear exploded perspective view of a display module in the display apparatus according to an embodiment of the present disclosure.
FIG. 6 is an enlarged view of the display module of FIG. 5.
FIG. 7 is a rear view of a display module in the display apparatus according to an embodiment of the present disclosure.
FIG. 8 is a front view of a cabinet and a circuit case in the display apparatus according to an embodiment of the present disclosure.
FIG. 9 is a cross-sectional view of the display apparatus according to an embodiment of the present disclosure.
FIG. 10 is an enlarged perspective view of the display apparatus according to an embodiment of the present disclosure.
FIG. 11 is a cross-sectional view of the display apparatus according to an embodiment of the present disclosure.
FIG. 12 is an enlarged perspective view of the display apparatus according to an embodiment of the present disclosure.
FIG. 13 is an enlarged perspective view of the display apparatus according to an embodiment of the present disclosure.
FIG. 14 is an enlarged perspective view of the display apparatus according to an embodiment of the present disclosure.

### [MODES OF THE INVENTION]

The embodiments and configurations illustrated in the drawings described in the present disclosure are merely preferred examples of the present disclosure, and at the time of filing this application, there may be various modifications that may replace the embodiments and drawings of the present disclosure.

In addition, the same reference numerals or symbols presented in each drawing of the present disclosure represent parts or constituent elements that perform substantially the same function.

In addition, the terms used in the present disclosure are used for the purpose of describing embodiments and are not intended to limit and/or restrict the present disclosure. Singular expressions include plural expressions unless clearly described as different meanings in the context. In the present disclosure, it should be understood the terms "comprises," "comprising," "includes," "including," "containing," "has," "having" or other variations thereof are inclusive and therefore specify the presence of stated features, integers, steps, operations, elements, components, or combinations thereof, but do not preclude the presence or addition of one or more other features, integers, steps, operations, elements, components, or combinations thereof.

In addition, terms such as "first," "second," and the like, which include ordinal numbers, may be used to describe various constituent elements in the present disclosure, but the constituent elements are not limited by these terms. These terms are used solely for the purpose of distinguishing one constituent element from another constituent element. For example, a first constituent element may be named a second constituent element, and similarly, the second constituent element may also be named the first constituent element, without departing from the scope of the present disclosure. The term "and/or" includes any and all combinations of a plurality of the related and listed items.

**In** addition, in the present disclosure, the meaning of "identical" includes cases where attributes are similar to each other or are similar within a certain range. Further, identical means "substantially identical". The meaning of "substantially identical" should be understood to include values that fall within the range of identical, where the values correspond to differences that fall within a tolerance range in manufacturing, or differences that fall within a range that does not have significance with respect to a reference value or a standard value.

In addition, the term "part," "device," "block," "member," "module," or the like may mean a unit that processes one or more functions or operations. For example, the term may mean at least one process processed by at least one hardware stored in a field-programmable gate array (FPGA), an application specific integrated circuit (ASIC), or the like, or at least one software or processor stored in a memory.

Meanwhile, the terms "front," "rear," "left," and "right" used in the following description are defined based on the drawings, and the shape and position of each constituent element are not limited by these terms.

Hereinafter, embodiments according to the present disclosure will be described in detail with reference to the accompanying drawings.

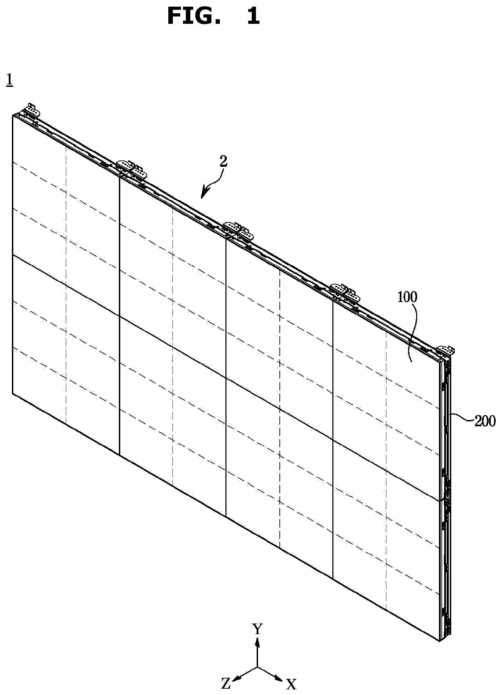

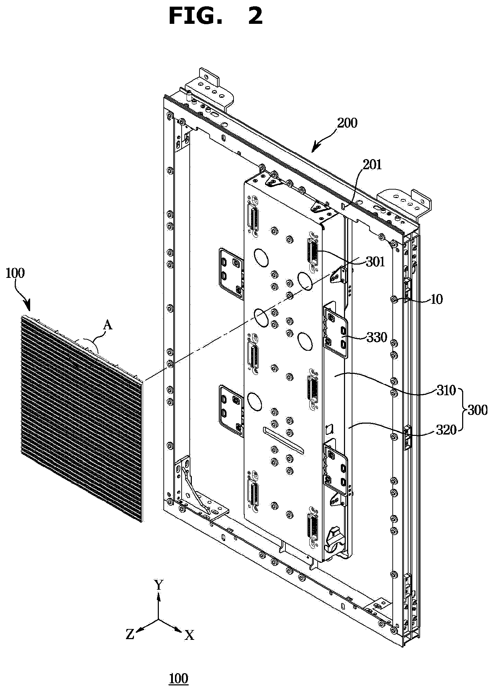

FIG. 1 is a perspective view of a display apparatus according to an embodiment of the present disclosure. FIG. 2 is an exploded perspective view of a display in the display apparatus according to an embodiment of the present disclosure. FIG. 2 is a view illustrating, from the front, a cabinet and a display module separated from the cabinet, in the display apparatus according to an embodiment of the present disclosure.

In FIG. 1, X-axis, Y-axis, and Z-axis directions perpendicular to each other are indicated, the X-axis direction may indicate a left-right direction, the Y-axis direction may indicate an up-down direction, and the Z-axis direction may indicate a front-rear direction. However, the meanings of the X-axis, Y-axis, and Z-axis directions are not limited to the above example and may be variously changed.

With reference to FIGS. 1 and 2, a display apparatus 1 displays information, material, data, and the like in the form of characters, figures, graphs, images, or the like and billboards, electric signboards, screens, televisions, monitors, and the like may be implemented as the display apparatus 1. The display apparatus 1 may be installed on a wall or ceiling, or may be installed on an indoor or outdoor ground by a stand.

The display apparatus 1 may include a display 2. For example, the display apparatus 1 may include a plurality of displays 2. In FIG. 1, the number of displays 2 included in the display apparatus 1 is illustrated as eight, but the number of displays 2 is not limited thereto.

The display 2 may include a display module 100 that displays a screen, a cabinet 200 that is coupled to the rear side of the display module 100 to support the display module 100, and a circuit case 300 that is coupled to the cabinet 200 and accommodates electric components and/or a printed circuit board therein.

In the display apparatus 1 according to an embodiment, one cabinet 200 may be coupled with six display modules 100. Specifically, in one cabinet 200, two display modules 100 may be coupled in a left-right direction (X direction), and three display modules 100 may be coupled in an up-down direction (Y direction). That is, the display modules 100 may be coupled to the cabinet 200 in a 2 × 3 matrix form. However, the number of display modules 100 coupled to the cabinet 200 is not limited thereto. Two or more display modules 100 may be coupled to one cabinet 200.

With reference to FIG. 1, the display apparatus 1 according to an embodiment of the present disclosure may include eight displays 2. For example, the display apparatus 1 may include eight cabinets 200 and forty-eight display modules 100 coupled to the eight cabinets 200. As such, the display apparatus 1 may implement a large-sized screen by arranging a plurality of cabinets 200, to which a plurality of display modules 100 are coupled, adjacent to each other in the left-right direction (X direction) and the up-down direction (Y direction). The number of the plurality of cabinets 200 arranged adjacent to each other in the left-right direction (X direction) and the up-down direction (Y direction) is not limited, and as described above, the number of the plurality of display modules 100 coupled to the cabinet 200 is also not limited.

With reference to FIG. 2, the display module 100 may be detachably coupled to the cabinet 200. The display module 100 may be separated from the cabinet 200 to the front side of the cabinet 200.

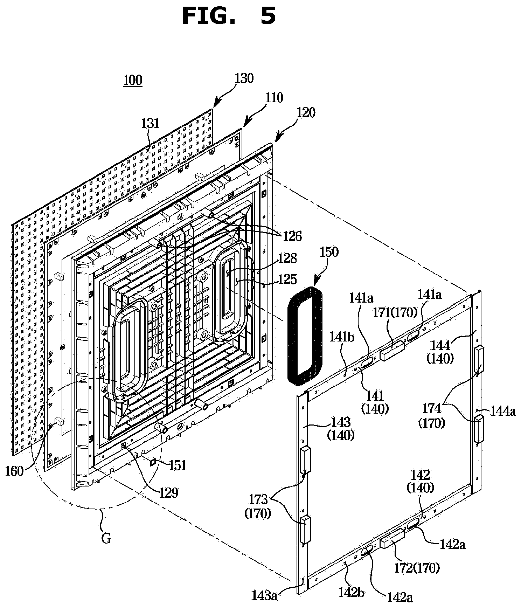

The display module 100 may be coupled to the cabinet 200 by magnetic force. The cabinet 200 and the circuit case 300 may include a plurality of magnets 10 provided on a front surface thereof. The plurality of magnets 10 may include a plurality of first magnets 10 provided on a front surface of the cabinet 200. The plurality of magnets 10 may include a plurality of second magnets 10 provided on a front surface of the circuit case 300. The display module 100 may include a reinforcing member 140 (see FIG. 5) that is provided on the rear side of the display module 100, and is coupled by magnetic attraction with the plurality of first magnets 10 and the plurality of second magnets 10. The plurality of first magnets 10 provided in the cabinet 200 and the plurality of second magnets 10 provided in the circuit case 300 may have the same configuration. The plurality of first magnets 10 and the plurality of second magnets 10 may be collectively referred to as the plurality of magnets 10.

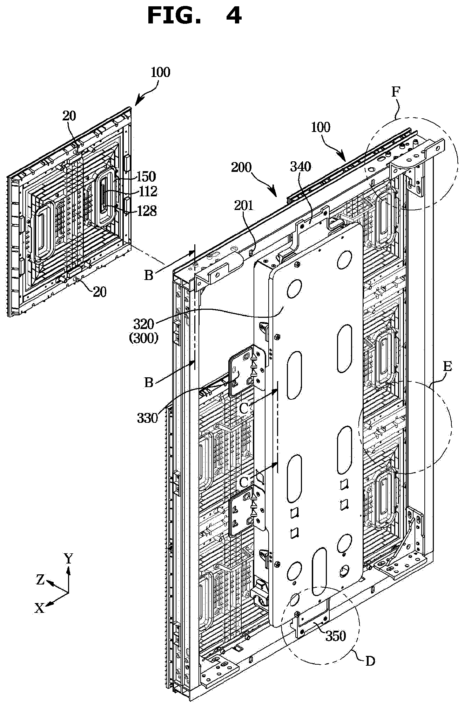

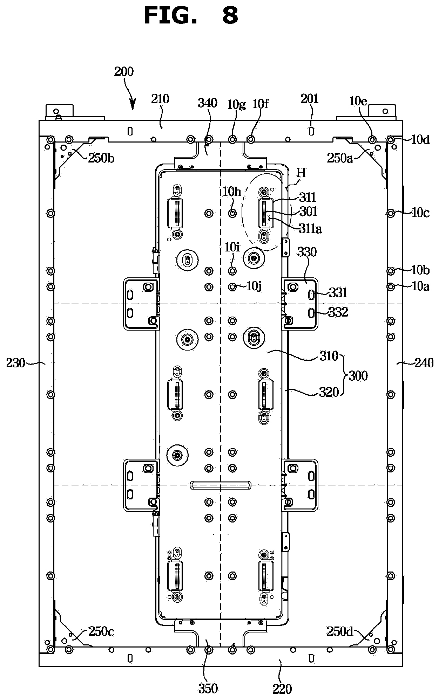

The cabinet 200 may include a frame 210, 220, 230 and 240 forming an outer edge of the cabinet 200 (see FIG. 8). The circuit case 300 may be disposed inside the frames 210, 220, 230, and 240. The circuit case 300 may include a second connector 301 corresponding to a first connector 112 (see FIG. 4) included in each of a plurality of display modules 100. The circuit case 300 may include a first case 310 having a hexahedral shape with one open surface, and a second case 320 provided to cover the one open surface of the first case 310.

The plurality of display modules 100 may be electrically connected to each other by coupling the first connector 112 of each of the plurality of display modules 100 with the second connectors 301 of the circuit case 300. In addition, the plurality of display modules 100 may be supplied with power from a power supply device disposed inside the circuit case 300.

Because the first connector 112 is formed in the display module 100, it may be referred to as a display connector 112, and because the second connector 301 is formed in the circuit case 300, it may be referred to as a circuit connector 301.

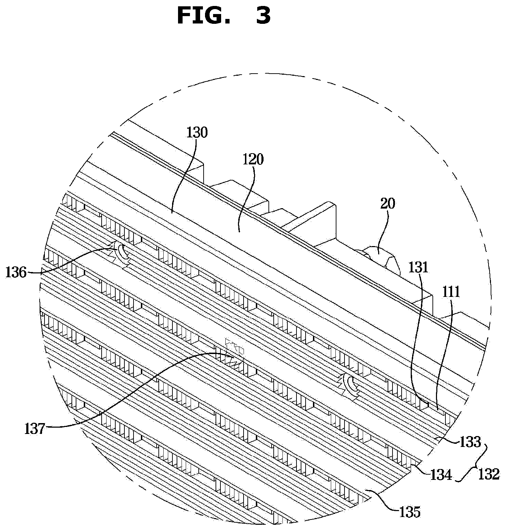

FIG. 3 is a partially enlarged view of the display apparatus of FIG. 2. FIG. 3 is an enlarged view of a region 'A' of FIG. 2.

With reference to FIG. 3, the display module 100 may include a substrate 110 (see FIG. 5), and a holder 120 that covers a lateral side and a rear side of the substrate 110, and supports the substrate 110. The holder 120 may be injection-molded. The substrate 110 may be attached to a front surface of the holder 120 by an adhesive, a double-sided adhesive tape, or the like, or may be coupled to the holder 120 by fastening members such as screws.

A plurality of light-emitting diodes (LEDs) 111 may be mounted on a front surface of the substrate 110. The substrate 110 may be formed of a material such as glass, polyimide (PI), or FR4.

Each of the plurality of LEDs 111 may include a red LED, a green LED, and a blue LED packaged as one pixel. The plurality of LEDs 111 may be mounted on the substrate 110 in a matrix form. A plurality of LEDs 111 may be arranged at regular intervals, and an interval between the plurality of LEDs 111 may be variously determined according to a resolution and a size of the display apparatus 1.

The display module 100 may include a cover plate 130 provided to cover a front side of a substrate 110. The cover plate 130 may include a plurality of LED holes 131 respectively corresponding to the plurality of LEDs 111 mounted on the substrate 110. Through the plurality of LED holes 131, the plurality of LEDs 111 may be exposed to a front surface of the cover plate 130.

The substrate 110 may be accommodated in the cover plate 130 and a holder 120. The cover plate 130 and the holder 120 may form an internal space accommodating the substrate 110 by being coupled to each other.

The cover plate 130 may include a louver portion 132. The louver portion 132 may include a horizontal louver portion 133 and a vertical louver portion 134. The louver portion 132 may reduce or block moisture introduced into the plurality of LEDs 111. In addition, the cover plate 130 may include a roof portion 135 provided above the plurality of LEDs 111. The roof portion 135 may protrude to a front side of the cover plate 130 and may prevent water from being directly introduced from an upper side into the plurality of LEDs 111.

The cover plate 130 may include a fastening hole 136 into which a fastening member for coupling the cover plate 130, the substrate 110, and the holder 120 is inserted, and a fixing hole 137 into which a fixing member 20 is inserted.

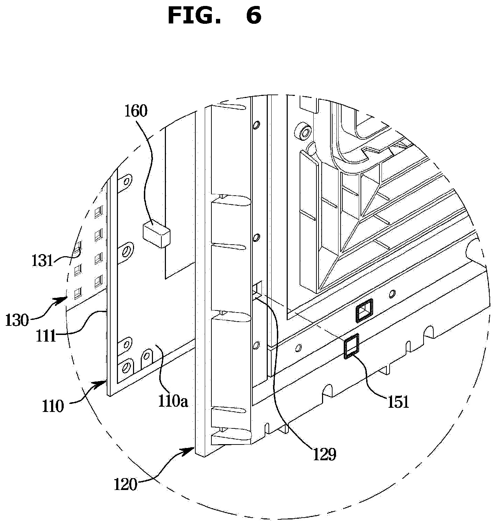

FIG. 4 is a rear exploded perspective view of a display in the display apparatus according to an embodiment of the present disclosure. FIG. 5 is a rear exploded perspective view of a display module in the display apparatus according to an embodiment of the present disclosure. FIG. 6 is an enlarged view of the display module of FIG. 5. FIG. 6 is an enlarged view of a region 'G' illustrated in FIG. 5.

With reference to FIGS. 4 to 6, the display module 100 may be separated to a front side of the cabinet 200. For example, when a force equal to or greater than magnetic attraction between the cabinet 200 and the display module 100 is applied to the display module 100 in a direction opposite to the magnetic attraction, the display module 100 may be separated from the cabinet 200.

The display module 100 may be coupled to the cabinet 200 by magnetic force. A plurality of magnets 10 (see FIG. 2) may be provided on a front surface of the cabinet 200, and a reinforcing member 140 pulled by the magnetic attraction of the plurality of magnets 10 may be provided on a rear side of the display module 100.

The reinforcing member 140 may be coupled to a rear side of the holder 120. The reinforcing member 140 may be disposed along a rear edge of the holder 120.

The reinforcing member 140 may include a first reinforcing member 141, a second reinforcing member 142, a third reinforcing member 143, and a fourth reinforcing member 144. The first reinforcing member 141 may be provided adjacent to an upper rear edge of the holder 120 and may extend in a horizontal direction. The second reinforcing member 142 may be provided adjacent to a lower rear edge of the holder 120 and may extend in a horizontal direction. The third reinforcing member 143 may be provided adjacent to a left rear edge of the holder 120 and may extend in a vertical direction. The fourth reinforcing member 144 may be provided adjacent to a right rear edge of the holder 120 and may extend in a vertical direction.

However, the above example is not limited thereto, and the first reinforcing member 142 may be a reinforcing member 142 that is provided adjacent to the lower rear edge of the holder 120 and extends in a horizontal direction. In addition, the first reinforcing member 143 may be a reinforcing member 143 that is provided adjacent to the left rear edge of the holder 120 and extends in a vertical direction. In addition, the first reinforcing member 144 may be a reinforcing member 144 that is provided adjacent to the right rear edge of the holder 120 and extends in a vertical direction.

**In** addition, the second reinforcing member, the third reinforcing member, and the fourth reinforcing member may also be disposed at positions different from those described above.

The reinforcing member 140 may reinforce strength of the display module 100 by being coupled to a rear surface of the holder 120. The reinforcing member 140 may prevent the display module 100 from bending. The reinforcing member 140 may prevent physical deformation of the display module 100.

The reinforcing member 140 may be formed of a material that is pulled by magnetic force of the magnets 10. The reinforcing member 140 may be formed of a material that is magnetizable by external magnetic force. The reinforcing member 140 may attract the magnets 10 by a polarity obtained by the reinforcing member 140 due to the external magnetic force. The reinforcing member 140 may be configured to include a magnetic material that interacts with the magnets 10. For example, the reinforcing member 140 may include iron (Fe).

The display module 100 may include a fixing member 20. The fixing member 20 may be disposed at an upper rear side and a lower rear side of the display module 100, respectively. However, a position of the fixing member 20 is not limited to the above example.

The cabinet 200 may include a through-hole 201 provided to allow the fixing member 20 to pass therethrough. The fixing member 20 may be rotatably provided between a coupling release position, in which the fixing member 20 can pass through the through-hole 201, and a coupling position, in which a protrusion 22 is caught by the through-hole 201 to prevent the fixing member 20 from passing through the through-hole 201.

The display module 100 may include a first connector hole 128 configured to expose a first connector 112 provided at a rear side of a substrate 110 to a rear side of the display module 100. The first connector hole 128 may be referred to as a display connector hole 128. The holder 120 may be formed with a sealing groove 125 configured to seal the first connector hole 128, and a sealing member 150 may be provided in the sealing groove 125.

The sealing member 150 may be provided to correspond to a shape of the sealing groove 125. The sealing member 150 may be provided in a substantially ring shape. The sealing member 150 may be formed of a material capable of volume change, for example, may include rubber.

According to an embodiment, the sealing member 150 may be attached to a rear surface of the display module 100, but is not limited thereto. The sealing member 150 may also be attached to a front surface of a circuit case 300 to correspond to the sealing groove 125.

A grounding member 160 may be disposed at a rear side of the substrate 110. For example, the grounding member 160 may be in contact with a rear surface 110a of the substrate 110. The grounding member 160 may be electrically connected to the substrate 110. For example, the grounding member 160 may be soldered to a circuit pattern provided on the rear surface 110a of the substrate 110.

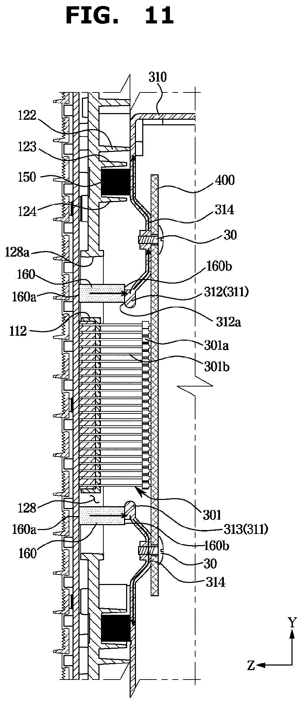

Although not shown in FIGS. 5 and 6, the grounding member 160 may be disposed in a region adjacent to the connector 112 (see FIG. 11). Because more electromagnetic waves may be generated from the connector 112 than from other components of the display apparatus 1, the grounding member 160 may emit such electromagnetic noise to an outside of the display apparatus 1 via the cabinet side.

The grounding member 160 may be formed of a material having excellent electrical conductivity. The grounding member 160 may extend in one direction. For example, the grounding member 160 may extend in a front-rear direction. The grounding member 160 may be referred to as a grounding gasket 160. The grounding member 160 may have a cross-sectional area much smaller than an area of the substrate 110 and the reinforcing member 140.

The holder 120 may include a ground hole 129 provided to allow at least a portion of the grounding member 160 to pass therethrough. The ground hole 129 may be provided at a position corresponding to the grounding member 160 and in a size corresponding to the grounding member 160. When the grounding member 160 is accommodated in the ground hole 129, the grounding member 160 may be in a compressed state.

The grounding member 160 may be referred to as a substrate grounding member 160 in contact with the substrate 110. The grounding member 160 may be referred to as a first grounding member 160.

The display module 100 may include a ground sealing member 151 provided to surround the ground hole 129. The ground sealing member 151 may be provided to seal around the ground hole 129. The ground sealing member 151 may be disposed between the reinforcing member 140 and the holder 120 to surround the ground hole 129. For example, the ground sealing member 151 may be disposed between an inner wall of the holder 120 forming the ground hole 129 and the grounding member 160 to seal between the inner wall of the holder 120 and the grounding member 160. The ground sealing member 151 may be provided between a rear side of the holder 120 and the reinforcing member 140. The ground sealing member 151 may seal between the holder 120 and the reinforcing member 140 to block water inflow into the ground hole 129. The ground sealing member 151 may have a closed-loop shape to block water inflow into the ground hole 129 from all directions, i.e., up, down, left, and right.

Even though the grounding member 160 has a small cross-sectional area, it may emit electromagnetic noise generated from the substrate 110 on which the LED 111 is mounted to the reinforcing member 140 and the cabinet 200. In addition, because the ground hole 129 is provided in a size corresponding to the grounding member 160, and the ground sealing member 151 is provided on an inner wall of the holder 120 forming the ground hole 129, water inflow from the cabinet 200 side to the substrate 110 side may be prevented.

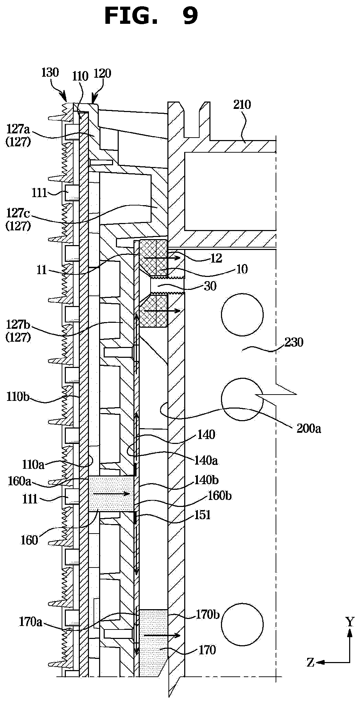

The reinforcing member 140 may be provided to contact at least a portion of the grounding member 160 protruding to a rear side of the holder 120 through the ground hole 129. The reinforcing member 140 may contact the grounding member 160 and the magnet 10 of the cabinet 200. The reinforcing member 140 may be formed of a material having excellent electrical conductivity. The reinforcing member 140, when a surge occurs in the substrate 110 and/or when electromagnetic noise is generated, may flow overcurrent and/or the electromagnetic noise from the grounding member 160 via the magnet 10 to the cabinet 200. The overcurrent and/or the electromagnetic noise caused by the surge may flow to the cabinet 200 via the reinforcing member 140 in contact with the grounding member 160, and the magnet 10 in contact with the reinforcing member 140 (see FIG. 9). Through this, it is possible to prevent components such as the plurality of LEDs 111 mounted on the substrate 110 from being damaged due to the surge. The reinforcing member 140, in a broad sense, may function as a grounding surface.

In addition, the grounding member 160 may be disposed at a position adjacent to the connectors 112 and 301 (see FIG. 11). In a region adjacent to the connectors 112 and 301, more electromagnetic noise may be generated, and to emit the electromagnetic noise, the grounding member 160 may be disposed at a position adjacent to the connectors 112 and 301. For example, the grounding member 160 may be disposed above and below the connectors 112 and 301, respectively.

The reinforcing member 140 may be formed with through-holes 141a and 142a and screw holes 141b, 142b, 143a, and 144a to mount the reinforcing member 140 to the holder 120. The holder 120 may be provided with penetrating protrusions 126 that pass through the through-holes 141a and 142a. The penetrating protrusions 126 may protrude to a rear side. The penetrating protrusions 126 may be provided one each at an upper portion and a lower portion of the holder 120.

The display module may include a cabinet grounding member 170. The cabinet grounding member 170 may be disposed at a rear side of the reinforcing member 140. For example, the cabinet grounding member 170 may be disposed on a rear surface of the reinforcing member 140 and may transmit electromagnetic noise generated from the substrate 110 to the cabinet 200 side (see FIG. 11). The cabinet grounding member 170 may be formed of a material having excellent electrical conductivity. The cabinet grounding member 170 may be referred to as a second grounding member 170.

The cabinet grounding member 170 may include a first cabinet grounding member 171, a second cabinet grounding member 172, a third cabinet grounding member 173, and a fourth cabinet grounding member 174.

The first cabinet grounding member 171 may be disposed at a rear side of the first reinforcing member 141. For example, the first cabinet grounding member 171 may be disposed on a rear surface of the first reinforcing member 141. In addition, the first cabinet grounding member 171 may be disposed between a plurality of through-holes 141a provided in the first reinforcing member 141 to mount the first reinforcing member 141 to the holder 120.

The second cabinet grounding member 172 may be disposed at a rear side of the second reinforcing member 142. For example, the second cabinet grounding member 172 may be disposed on a rear surface of the second reinforcing member 142. In addition, the second cabinet grounding member 172 may be disposed between a plurality of through-holes 142a provided in the second reinforcing member 142 to mount the second reinforcing member 142 to the holder 120.

The third cabinet grounding member 173 may be disposed at a rear side of the third reinforcing member 143. For example, the third cabinet grounding member 173 may be disposed on a rear surface of the third reinforcing member 143. In addition, the third cabinet grounding member 173 may be disposed between a plurality of screw holes 143a provided in the third reinforcing member 141 to mount the third reinforcing member 143 to the holder 120. The third cabinet grounding member 173 may be provided in plurality.

The fourth cabinet grounding member 174 may be disposed at a rear side of the fourth reinforcing member 144. For example, the fourth cabinet grounding member 174 may be disposed on a rear surface of the fourth reinforcing member 144. In addition, the fourth cabinet grounding member 174 may be disposed between a plurality of screw holes 144a provided in the fourth reinforcing member 144 to mount the fourth reinforcing member 144 to the holder 120. The fourth cabinet grounding member 174 may be provided in plurality.

However, a position of the cabinet grounding member 170 is not limited to the above example. For example, the first cabinet grounding member 171 may also be disposed at a rear side of the second reinforcing member 142, or may be disposed at a rear side of the third reinforcing member 143, or may be disposed at a rear side of the fourth reinforcing member 144. In addition, the second cabinet grounding member 172, the third cabinet grounding member 173, and the fourth cabinet grounding member 174 may also be disposed on a reinforcing member different from the above examples.

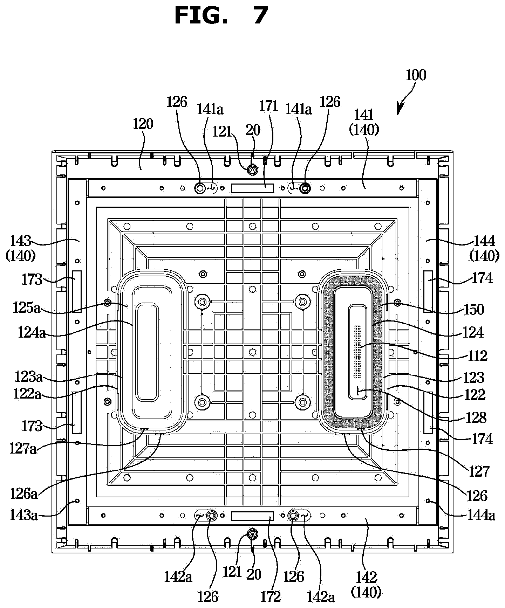

FIG. 7 is a rear view of a display module in the display apparatus according to an embodiment of the present disclosure.

With reference to FIG. 7, the reinforcing member 140 may be coupled to a rear surface of the holder 120. The reinforcing member 140 may be disposed along an edge of the rear surface of the holder 120. The reinforcing member 140 may include a first reinforcing member 141, a second reinforcing member 142, a third reinforcing member 143, and a fourth reinforcing member 144. The first reinforcing member 141 may be provided adjacent to an upper rear edge of the holder 120 and may extend in a horizontal direction. The second reinforcing member 142 may be provided adjacent to a lower rear edge of the holder 120 and may extend in a horizontal direction. The third reinforcing member 143 may be provided adjacent to a left rear edge of the holder 120 and may extend in a vertical direction. The fourth reinforcing member 144 may be provided adjacent to a right rear edge of the holder 120 and may extend in a vertical direction.

The reinforcing member 140 may reinforce strength of the display module 100 by being coupled to a rear surface of the holder 120. The reinforcing member 140 may prevent the display module 100 from bending. The reinforcing member 140 may prevent physical deformation of the display module 100.

The reinforcing member 140 may be formed of a material that is pulled by magnetic force of the magnets 10. The reinforcing member 140 may be formed of a material that is magnetizable by external magnetic force. The reinforcing member 140 may attract the magnets 10 by a polarity obtained by the reinforcing member 140 due to the external magnetic force. The reinforcing member 140 may be configured to include a magnetic material that interacts with the magnets 10. The reinforcing member 140 may include iron (Fe).

The display module 100 may include a fixing member 20. The fixing member 20 may be provided one each at an upper rear side and a lower rear side of the display module 100. According to an embodiment, the fixing member 20 may be provided at a central upper rear side and a central lower rear side of the display module 100, but the position thereof is not limited thereto.

The fixing member 20 may prevent the display module 100 from being separated from the cabinet 200. The display module 100 may be coupled by magnetic attraction between the plurality of magnets 10 and the reinforcing member 140, but when a force equal to or greater than the magnetic attraction is applied to the display module 100 to separate the display module 100 from the cabinet 200, the display module 100 may be separated from the cabinet 200. To prevent this, the fixing member 20 may be provided to prevent the display module 100 from moving forward from the cabinet 200.

The display module 100 may include a first connector hole 128 configured to expose a first connector 112 provided at a rear side of a substrate 110 to a rear side of the display module 100. The display module 100 may include a first waterproof rib 122, a second waterproof rib 123, and a third waterproof rib 124, each protruding rearward from a rear surface of the holder 120, to block water inflow into the first connector hole 128. A sealing groove 125 (see FIG. 5) may be formed between the second waterproof rib 123 and the third waterproof rib 124, and a sealing member 150 may be provided in the sealing groove 125.

The first waterproof rib 122, the second waterproof rib 123, and the third waterproof rib 124 may each be provided in a ring shape. Inside the first waterproof rib 122, the second waterproof rib 123 may be provided, and inside the second waterproof rib 123, the third waterproof rib 124 may be provided.

The first to third waterproof ribs 122, 123, and 124 may block moisture from being introduced inward from the outside of the first to third waterproof ribs 122, 123, and 124 by contacting a front surface of the circuit case 300.

A sealing member 150 may be provided in a sealing groove 125 formed between the second waterproof rib 123 and the third waterproof rib 124. The sealing member 150 may be provided to correspond to a shape of the sealing groove 125. The sealing member 150 may be provided in a substantially ring shape. The sealing member 150 may be formed of a material capable of volume change, for example, may include rubber.

According to an embodiment, the sealing member 150 may be attached to a rear surface of the display module 100, but is not limited thereto. The sealing member 150 may also be attached to a front surface of a circuit case 300 to correspond to the sealing groove 125.

The display module 100 may include the first waterproof rib 122, the second waterproof rib 123, the third waterproof rib 124, the sealing groove 125, and the first waterproof rib 122a, the second waterproof rib 123a, the third waterproof rib 124a, and the sealing groove 125a that are provided symmetrically on the left and right sides. For convenience, the first to third waterproof ribs 122a, 123a, and 124a may be referred to as left waterproof ribs, and the first to third waterproof ribs 122, 123, and 124 may be referred to as right waterproof ribs.

The left waterproof ribs 122a, 123a, 124a and the right waterproof ribs 122, 123, 124 may be provided in a left-right symmetric and identical structure. This is to allow the display module 100 to be coupled to both left and right columns of the two columns of the cabinet 200. For example, when the display module 100 is coupled to the right column of the cabinet 200, the first connector 112 may be disposed inside the right waterproof ribs 122, 123, and 124, and to prevent water from being introduced into the first connector 112, the sealing member 150 may be provided in the right sealing groove 125. Conversely, when the display module 100 is coupled to the left column of the cabinet 200, the first connector 112 may be disposed inside the left ribs 122a, 123a, and 124a, and the sealing member 150 may be provided in the left sealing groove 125a. Additionally, a first connector hole may not be provided inside the waterproof rib where the first connector 112 is not disposed. With reference to FIG. 7, a first connector hole may not be provided inside the left third waterproof rib 124a, and a first connector hole 128 may be provided inside the right third waterproof rib 124 to expose the first connector 112.

FIG. 8 is a front view of a cabinet and a circuit case in the display apparatus according to an embodiment of the present disclosure.

With reference to FIG. 8, the cabinet 200 may include frames 210, 220, 230, and 240 extending in one direction. For example, the cabinet 200 may be formed by coupling four frames 210, 220, 230, and 240 extending in one direction. The four frames 210, 220, 230, and 240 may be coupled to each other by four corner brackets 250a, 250b, 250c, and 250d.

For example, the frames 210, 220, 230, and 240 may include a first frame 210 forming an upper edge of the cabinet 200, a second frame 220 forming a lower edge of the cabinet 200, a third frame 230 forming a left edge of the cabinet 200, and a fourth frame 240 forming a right edge of the cabinet 200. The first frame 210 and the second frame 220 may be disposed in a horizontal direction, and the third frame 230 and the fourth frame 240 may be disposed in a vertical direction.

However, the positions of the frames 210, 220, 230, and 240 are not limited to the above example. For example, the first frame may form a lower, left, or right edge of the cabinet. **In** addition, the second frame may form an upper, left, or right edge of the cabinet. **In** addition, the third frame may form an upper, lower, or right edge of the cabinet. Further, the fourth frame may form an upper, lower, or left edge of the cabinet.

The cabinet 200 may further include a corner bracket 250. The corner bracket 250 may include a first corner bracket 250a, a second corner bracket 250b, a third corner bracket 250c, and a fourth corner bracket 250d.

The first frame 210 and the fourth frame 240 may be coupled by the first corner bracket 250a. The first frame 210 and the third frame 230 may be coupled by the second corner bracket 250b. The second frame 220 and the third frame 230 may be coupled by the third corner bracket 250c, and the second frame 220 and the fourth frame 240 may be coupled by the fourth corner bracket 250d.

The first to fourth frames 210, 220, 230, and 240 may be coupled to each other by the first to fourth corner brackets 250a, 250b, 250c, and 250d to have a rectangular frame shape.

In addition, the frames 210, 220, 230, and 240 that can be coupled by the first to fourth corner brackets 250a, 250b, 250c, and 250d are not limited to the above example.

The circuit case 300 may be located at a central inner side of the frames 210, 220, 230, and 240. The circuit case 300 may be coupled to the frames 210, 220 by a first connection bracket 340 and a second connection bracket 350 respectively provided at an upper side and a lower side of the circuit case 300.

The circuit case 300 may include a first case 310 forming a front surface and side surface of the circuit case 300 and having a rear surface open, and a second case 320 provided to cover the open rear surface of the first case 310. The first case 310 and the second case 320 may be coupled to each other to form the circuit case 300. The first case 310 and the second case 320 may be coupled to each other to be sealed inside. The first case 310 and the second case 320 may be coupled to each other to block water inflow from the outside.

At a front portion of the first case 310, a second connector hole 311a may be provided. The first case 310 may include a rib 311 that is provided along a periphery of the second connector hole 311a and protrudes toward a front side. Inside the second connector hole 311a, a second connector 301 may be disposed.

The second connector hole 311a, the second connector 301, and the rib 311 may be provided to correspond to the number of display modules 100 coupled to the cabinet 200. The second connector hole 311a may be referred to as a circuit connector hole 311a.

Inside the circuit case 300, a power supply device provided to supply power to the display module 100, a control board provided to control the display module 100, and the like may be provided. In the present specification, the electric component may include the above-described power supply device and control board.

The circuit case 300 may include a support bracket 330 provided to support the display module 100. The support bracket 330 may be coupled to both sides of the circuit case 300. In addition, the support bracket 330 may be respectively provided one each in an up-down direction as both sides of the circuit case 300. According to an embodiment, four support brackets 330 may be coupled to the circuit case 300.

The display apparatus may further include connection brackets 340 and 350. The connection brackets 340 and 350 may connect the circuit case 300 and the cabinet 200. The connection brackets may be respectively coupled to the frames 210, 220, 230, 240 and the circuit case 300. The connection brackets 340 and 350 may include a first connection bracket 340 and a second connection bracket 350. The first connection bracket 340 may be provided at an upper side of the circuit case 300 to connect the cabinet 200 and the circuit case 300, and the second connection bracket 350 may be provided at a lower side of the circuit case 300 to connect the cabinet 200 and the circuit case 300.

The cabinet 200 may include a plurality of magnets 10. In addition, the circuit case 300 may include a plurality of magnets 10.

Specifically, the cabinet 200 may include a plurality of magnets 10 that are disposed spaced apart from each other on front surfaces of the first to fourth frames 210, 220, 230, and 240.

In addition, the circuit case 300 may include a plurality of magnets 10 that are disposed spaced apart from each other on a front surface of the circuit case 300.

In the display apparatus according to an embodiment, the cabinet 200 and the circuit case 300 may include ten magnets 10 per one display module 100. The cabinet 200 and the circuit case 300 may include a total of sixty magnets 10. The cabinet 200 may include thirty-eight magnets 10, and the circuit case 300 may include twenty-two magnets 10. However, the number and positions of the magnets 10 are not limited thereto, and the number and positions of the magnets 10 may be variable.

For example, in order to support the display module 100 coupled to an upper right portion of the cabinet 200, the cabinet 200 may include first to seventh magnets 10a, 10b, 10c, 10d, 10e, 10f, and 10g, and the circuit case 300 may include eighth to tenth magnets 10h, 10i, and 10j.

As described above, the plurality of magnets 10 may be formed of a magnetizable material and may couple the display module 100 to the cabinet 200 by magnetically attracting a reinforcing member 140 disposed at a rear side of the holder 120.

FIG. 9 is a cross-sectional view of the display apparatus according to an embodiment of the present disclosure. FIG. 9 is a cross-sectional view of the display apparatus taken along B-B', when the display module is coupled to the cabinet illustrated in FIG. 4.

With reference to FIG. 9, the display apparatus according to an embodiment may include a substrate 110 on which LEDs 111 are mounted, a holder 120 that covers a rear side of the substrate 110, and a reinforcing member 140 that is disposed at a rear side of the holder 120 and is screw-coupled to the holder 120.

The holder 120 may include a support portion 127. The support portion 127 may include a substrate support portion 127a that supports the substrate 110, a reinforcing member support portion 127b that supports the reinforcing member 140, and a cabinet support portion 127c that supports the cabinet 200.

The substrate support portion 127a may be in contact with a rear surface 110a of the substrate 110 to support the substrate 110. The substrate support portion 127a may be provided at a peripheral side of the holder 120. The reinforcing member support portion 127b may be in contact with a front surface 140a of the reinforcing member 140 to support the reinforcing member 140. The reinforcing member support portion 127b may be disposed inward of the substrate support portion 127a, and may be provided rearward of the substrate support portion 127a. The cabinet support portion 127c may be in contact with a front surface 200a of the cabinet 200 to support the cabinet 200. The cabinet support portion 127c may be disposed between the substrate support portion 127a and the reinforcing member support portion 127b along an up-down direction. The cabinet support portion 127c may be provided rearward of the reinforcing member support portion 127b.

The support portion 127 may be referred to as a contact portion 127. For example, the substrate support portion 127a may be referred to as a substrate contact portion 127a, the reinforcing member support portion 127b as a reinforcing member contact portion 127b, and the cabinet support portion 127c as a cabinet contact portion 127c.

On a front surface 110b of the substrate 110, LEDs 111 may be mounted, and a circuit pattern electrically connecting the LEDs 111 may be provided on the front surface 110b and the rear surface 110a of the substrate 110. In addition, various electronic components for driving the LEDs 111 may also be mounted on the substrate 110. Therefore, electromagnetic noise may be generated on the substrate 110, and there is a need to smoothly discharge such electromagnetic noise to the outside of the display apparatus so as not to adversely affect other components or electronic devices.

The display apparatus according to an embodiment may further include a grounding member 160. The grounding member 160 may be disposed between the substrate 110 and the reinforcing member 140. For example, a front surface 160a of the grounding member 160 may be in contact with the rear surface 110a of the substrate 110, and a rear surface 160b of the grounding member 160 may be in contact with a front surface 140a of the reinforcing member 140. The grounding member 160 may transmit and/or discharge the electromagnetic noise generated from the substrate 110 toward the reinforcing member 140. The grounding member 160 may be a substrate grounding member 160 that is in contact with the substrate 110. The substrate grounding member 160 may be in a compressed state when disposed between the substrate 110 and the reinforcing member 140.

The display apparatus according to an embodiment may include a magnet 10. The magnet 10 may be fastened to the reinforcing member 140 via a fastening member 30. The magnet 10 may be disposed between the reinforcing member 140 and the cabinet 200. For example, a front surface 11 of the magnet 10 may be in contact with a rear surface 140b of the reinforcing member 140, and a rear surface 12 of the magnet 10 may be in contact with a front surface 200a of the cabinet 200. The magnet 10 may transmit and/or discharge the electromagnetic noise generated from the substrate 110 and transmitted and/or discharged to the reinforcing member 140 toward the cabinet 200.

The display apparatus according to an embodiment may further include a cabinet grounding member 170. The cabinet grounding member 170 may be disposed between the reinforcing member 140 and the cabinet 200. For example, a front surface 170a of the cabinet grounding member 170 may be in contact with a rear surface 140b of the reinforcing member 140, and a rear surface 170b of the cabinet grounding member 170 may be in contact with a front surface 200a of the cabinet 200. The cabinet grounding member 170 may transmit and/or discharge the electromagnetic noise generated from the substrate 110 and transmitted and/or discharged to the reinforcing member 140 toward the cabinet 200 or the frames 210, 220, 230, 240.

In other words, the electromagnetic noise generated from the substrate 110 may flow to the frames 210, 220, 230, 240 and the cabinet 200 after sequentially passing through the substrate grounding member 160, the reinforcing member 140, and the magnet 10 and/or the cabinet grounding member 170.

Even if only one component among the magnet 10 or the cabinet grounding member 170 is present, the electromagnetic noise generated from the substrate 110 may be discharged and/or transmitted toward the cabinet 200. In addition, in the display apparatus according to an embodiment of the present disclosure, the means or components for discharging electromagnetic noise toward the cabinet 200 side are not limited to the above-described example.

The cabinet 200 may be connected and/or coupled to an external structure that is installed so that the display apparatus may be fixed and/or supported externally. The electromagnetic noise flowing into the cabinet 200 may flow into the external structure or directly flow to the ground, thereby implementing grounding of the display apparatus.

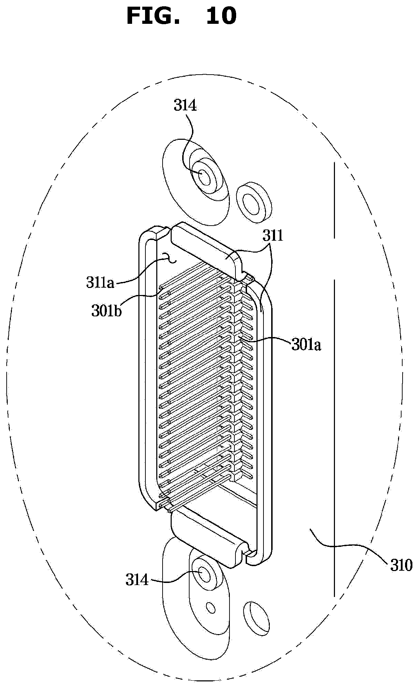

FIG. 10 is an enlarged perspective view of the display apparatus according to an embodiment of the present disclosure. FIG. 10 is an enlarged perspective view of region H of the display apparatus illustrated in FIG. 8. FIG. 11 is a cross-sectional view of the display apparatus according to an embodiment of the present disclosure. FIG. 11 is a cross-sectional view of the display apparatus illustrated in FIG. 4, taken along line C-C'.

With reference to FIGS. 10 and 11, the display apparatus according to an embodiment of the present disclosure may include a second connector 301. The second connector 301 may include a connector head 301a and connector pins 301b. The connector head 301a may be connected to a circuit board 400. The connector pins 301b may be inserted into the first connector 112.

The display apparatus according to an embodiment of the present disclosure may include a ground rib 311. The ground rib 311 may be provided in the second connector hole 311a. The ground rib 311 may surround the second connector hole 311a. For example, the ground rib 311 may protrude forward from an inner surface or inner wall of the circuit case 300 forming the second connector hole 311a.

The ground rib 311 may include an upper rib 312 and a lower rib 313. The upper rib 312 and the lower rib 313 may protrude further than the ground rib 311 provided on both sides of the second connector hole 311a (or circuit connector hole). The upper rib 312 and the lower rib 313 may be in contact with the grounding member 160. The upper rib 312 and the lower rib 313 may protrude in a direction toward the connectors 112 and 301 disposed in the connector hole 311a. For example, the upper rib 312 and the lower rib 313 may extend toward the center of the connector hole 311a.

The upper rib 312 may be referred to as a first rib 312, and the lower rib 313 may be referred to as a second rib 313. Conversely, the upper rib 312 may be referred to as the second rib 312, and the lower rib 313 may be referred to as the first rib 313.

The display apparatus according to an embodiment of the present disclosure includes a circuit board 400 accommodated in the circuit case 300. The circuit board 400 may be a power supply device provided to supply power to the display module 100, or a control board provided to control the display module 100.

The circuit board 400 may be accommodated in the first case 310, and may be screw-coupled to a circuit board fastening portion 314 provided at the front side of the first case 310. The circuit board fastening portion 314 may be provided above and below the connector hole 311a. The circuit board 400 may be electrically connected to the second connector 301. Additionally, the circuit board 400 may be coupled to the second connector 301. The circuit board 400 may be connected to the first connector 112 via the second connector 301, and may transmit or receive electrical signals to or from the display module 100. Accordingly, more electromagnetic noise may be generated in the area where the connectors 112 and 301 and the circuit board 400 are disposed compared to other areas of the display apparatus.

The electromagnetic noise generated from the circuit board 400 may flow to the circuit case 300 via the circuit board fastening portion 314 and the fastening member 30, and the electromagnetic noise flowing to the circuit case 300 may be transmitted and/or discharged to the cabinet 200.

The display apparatus according to an embodiment may further include a grounding member 160. The grounding member 160 may be disposed between the substrate 110 and the circuit case 300. For example, a front surface 160a of the grounding member 160 may contact a rear surface 110a of the substrate 110, and a rear surface 160b of the grounding member 160 may contact the ground rib 311 of the circuit case 300. The grounding member 160 may transmit and/or discharge electromagnetic noise generated from the substrate 110 to the circuit case 300 side. The grounding member 160 may be a substrate grounding member 160 that is in contact with the substrate 110.

The electromagnetic noise transmitted to the ground rib 311 may be transmitted to the contacted and connected cabinet 200.

In other words, the electromagnetic noise generated from the substrate 110, the connectors 112 and 301, and/or the circuit board 400 passes sequentially through the substrate grounding member 160 and the ground rib 311, and then flows through the circuit case 310 and via the connection brackets 340 and 350, etc., to the frames 210, 220, 230, and 240 and the cabinet 200.

The cabinet 200 may be connected and/or coupled to an external structure that is installed so that the display apparatus may be fixed and/or supported externally. The electromagnetic noise flowing into the cabinet 200 may flow into the external structure or directly flow to the ground, thereby implementing grounding of the display apparatus.

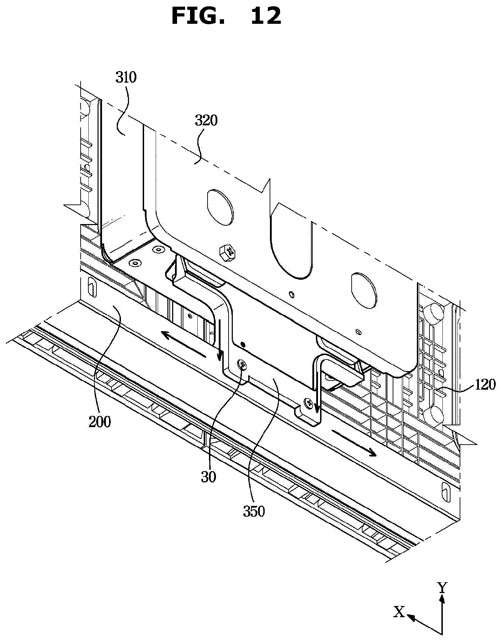

FIG. 12 is an enlarged perspective view of the display apparatus according to an embodiment of the present disclosure. FIG. 12 is an enlarged perspective view of region D in the display apparatus illustrated in FIG. 4.

With reference to FIG. 12, a display apparatus according to an embodiment of the present disclosure may include connection brackets 340 and 350. As illustrated in FIG. 11, electromagnetic noise generated from the substrate 110, the circuit board 400, and the connectors 112 and 301 may flow along the circuit case 300.

The electromagnetic noise may be transmitted and/or discharged from the circuit case 300 to the frames 210, 220, 230, and 240 or the cabinet 200 via the connection brackets 340 and 350. The electromagnetic noise transmitted and/or discharged to the frames 210, 220, 230, and 240 or the cabinet 200 may flow to an external structure or directly to the ground, thereby implementing grounding of the display apparatus.

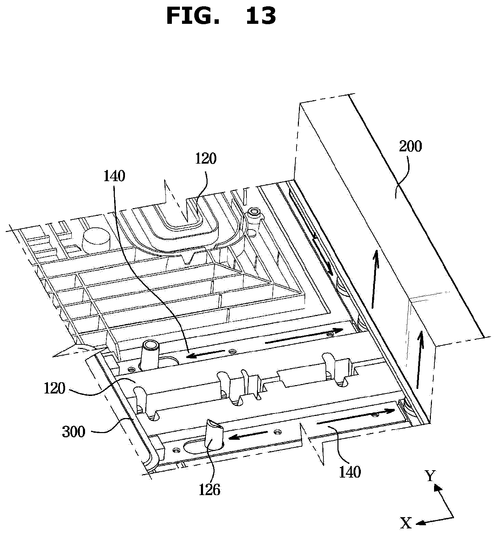

FIG. 13 is an enlarged perspective view of the display apparatus according to an embodiment of the present disclosure. FIG. 13 is an enlarged perspective view of region E in the display apparatus illustrated in FIG. 4.

With reference to FIG. 13, in a display apparatus according to an embodiment of the present disclosure, the display module 100 and the cabinet 200 may be coupled by magnetic attraction. For example, the reinforcing member 140 and the cabinet 200 may be coupled by the magnet 10.

In this case, as illustrated in FIG. 9, the electromagnetic noise flowing from the substrate 110 to the reinforcing member 140 may flow to the circuit case 300 and/or the cabinet 200. The electromagnetic noise transmitted and/or discharged to the cabinet 200 or the circuit case 300 may flow to an external structure or directly to the ground, thereby implementing grounding of the display apparatus.

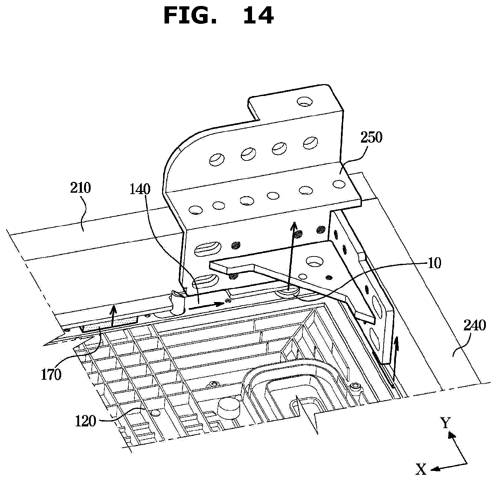

FIG. 14 is an enlarged perspective view of the display apparatus according to an embodiment of the present disclosure. FIG. 14 is an enlarged perspective view of region F in the display apparatus illustrated in FIG. 4.

With reference to FIG. 14, a display apparatus according to an embodiment of the present disclosure may include a corner bracket 250. The corner bracket 250 may be disposed at the ends of the plurality of frames 200 and may couple the frames 200 together.

As illustrated in FIGS. 9 and 11 to 13, the electromagnetic noise transmitted and/or discharged to the circuit case 300 and the cabinet 200 may flow to the corner bracket 250 disposed at the ends of the frames 200. The electromagnetic noise transmitted and/or discharged to the corner bracket 250 may flow to an external structure or directly to the ground, thereby implementing grounding of the display apparatus 1.

According to an embodiment, a display apparatus may include: a cabinet 200; a substrate 110 in which an LED 111 is mounted, and which is coupled to the cabinet; a reinforcing member 140 disposed between the substrate and the cabinet and coupled to the substrate; a magnet 10 disposed between the reinforcing member and the cabinet so that the substrate is coupled to the cabinet by magnetic attraction between the reinforcing member and the cabinet; and a grounding member 160 disposed between the substrate and the reinforcing member.

In the display apparatus according to an embodiment, the grounding member 160 may be provided such that electromagnetic noise, which is generated from the substrate where the LEDs are mounted, may be discharged via the substrate, the grounding member, the reinforcing member, the magnet, and the cabinet.

In the display apparatus according to an embodiment, the grounding member may be the substrate grounding member 160.

The display apparatus according to an embodiment may further include a cabinet grounding member 170 disposed between the reinforcing member and the cabinet, and provided such that the electromagnetic noise may be discharged via the reinforcing member, the cabinet grounding member 170, and the cabinet.

In the display apparatus according to an embodiment, the cabinet may include frames 210, 220, 230, and 240 including a first frame 210 and a second frame 220 that extend in different directions, and a corner bracket 250 that couples the first frame and the second frame.

In the display apparatus according to an embodiment, the electromagnetic noise may be discharged from the substrate grounding member via at least one of the reinforcing member, the magnet, or the cabinet grounding member, and the frames and the corner bracket.

The display apparatus according to an embodiment may further include a holder 120, which is disposed between the substrate and the reinforcing member and includes a ground hole corresponding to the grounding member.

The display apparatus according to an embodiment may further include a ground sealing member 151 disposed between the holder and the reinforcing member, and configured to seal between the grounding member and the ground hole.

According to an embodiment, a display apparatus may further include: a display connector 112 electrically connected to the substrate; a display connector hole 128 formed in the holder to expose the display connector; waterproof ribs 122, 123, and 124 formed in the holder to surround the display connector hole and prevent water from being introduced from the outside of the display connector hole 128 into the display connector hole; and a sealing member 150 disposed inside the waterproof ribs to seal between the display connector hole and the waterproof ribs.

The display apparatus according to an embodiment may further include: a circuit case 300 coupled to the cabinet and including a circuit connector hole 311a; a circuit connector 301 disposed in the circuit connector hole of the circuit case to transmit a signal to the substrate; and a ground rib 311 protruding from an edge forming the circuit connector hole of the circuit case.

In the display apparatus according to an embodiment, the ground rib 311 may protrude toward the substrate when the substrate is coupled to the cabinet.

In the display apparatus according to an embodiment, the ground rib 311 may include an upper rib 312 formed above the circuit connector and a lower rib 313 formed below the circuit connector.

The display apparatus according to an embodiment may further include a display connector 112 disposed on the substrate side and electrically connected to the circuit connector.

In the display apparatus according to an embodiment, the grounding member 160 may include: an upper grounding member 161 disposed above the display connector and in contact with the upper rib; and a lower grounding member 162 disposed above the display connector and in contact with the lower rib.

In the display apparatus according to an embodiment, electromagnetic noise generated from the circuit connector and the display connector may be discharged via the ground rib and the circuit case.

The display apparatus according to an embodiment may further include connection brackets 340 and 350 that couple the cabinet and the circuit case.

In the display apparatus according to an embodiment, electromagnetic noise generated from the substrate on which the LED is mounted, and electromagnetic noise generated from the circuit connector and the display connector, may be discharged via the ground rib, the circuit case, the connection brackets 340 and 350, and the cabinet.

In the display apparatus according to an embodiment, the cabinet may include frames 210, 220, 230, and 240 including a first frame 210 and a second frame 220 that extend in different directions, and a corner bracket 250 that couples the first frame and the second frame.

In the display apparatus according to an embodiment, the electromagnetic noise generated from the substrate on which the LED is mounted, and electromagnetic noise generated from the circuit connector and the display connector, may be discharged from the ground rib via the circuit case, the connection brackets, the frames, and the corner bracket.

The display apparatus according to an embodiment may include: a cabinet 200; a substrate 110, on which an LED 111 is mounted, coupled to the cabinet; a circuit case 300 coupled to the cabinet and forming a circuit connector hole 311a; a circuit connector 301 disposed in the circuit connector hole of the circuit case to transmit a signal to the substrate in which the LED is mounted; and a ground rib 311 protruding toward the substrate from an inner surface of the circuit case forming the circuit connector hole.

In the display apparatus according to an embodiment, the ground rib 311 may be provided such that electromagnetic noise generated from the substrate on which the LED is mounted and the circuit connector may be discharged via the ground rib, the circuit case, and the cabinet.

In the display apparatus according to an embodiment, the ground rib may include: an upper rib 312 formed above the circuit connector, and a lower rib 313 formed below the circuit connector.

The display apparatus according to an embodiment may further include: a display connector 112 disposed on the side of the substrate and electrically connected to the circuit connector; and a grounding member 160 disposed between the substrate and the circuit case.

In the display apparatus according to an embodiment, the grounding member 160 may include: an upper grounding member 161 disposed above the display connector and in contact with the upper rib; and a lower grounding member 162 disposed above the display connector and in contact with the lower rib.

The display apparatus according to an embodiment may further include connection brackets 340 and 350 that couple the cabinet and the circuit case.

In the display apparatus according to an embodiment, the electromagnetic noise may be discharged via the ground rib, the circuit case, the connection brackets 340 and 350, and the cabinet.

In the display apparatus according to an embodiment, the cabinet may include frames 210, 220, 230, and 240 including a first frame 210 and a second frame 220 that extend in different directions, and a corner bracket 250 that couples the first frame and the second frame.

In the display apparatus according to an embodiment, the electromagnetic noise may be discharged from the ground rib via the circuit case, the connection brackets, the frames, and the corner bracket.

In a display apparatus 1 including the cabinet 200 and a display module 100 coupled to the cabinet, the display module 100 may include: a substrate 110 on which an LED 111 is mounted; a holder 120 disposed at a rear side of the substrate to cover the substrate and including a ground hole 129; a reinforcing member 140 disposed at a rear side of the holder; and a grounding member 160 disposed on a rear surface of the substrate to contact the reinforcing member and to pass through the ground hole.

In the display apparatus according to an embodiment, the grounding member may be provided such that the electromagnetic noise generated from the substrate on which the LED is mounted may be discharged via the grounding member, the reinforcing member, and the cabinet.

The display apparatus according to an embodiment may further include: a magnet 10 disposed between the reinforcing member and the cabinet such that the display module is coupled to the cabinet by magnetic attraction between the reinforcing member and the cabinet; and a cabinet grounding member 170 disposed between the reinforcing member and the cabinet.

In the display apparatus according to an embodiment, the electromagnetic noise may be discharged via at least one of the reinforcing member, the magnet 10, or the cabinet grounding member 170, and the cabinet.

According to an embodiment of the present disclosure, it is possible to provide a display apparatus capable of reliably discharging electromagnetic noise while minimizing a waterproof area by using a grounding member that is applied to a small area, not a large area.

According to an embodiment of the present disclosure, electromagnetic noise may be reliably discharged, thereby reducing EMI (electromagnetic interference) affecting electronic components constituting the display apparatus or external electronic devices of the display apparatus.

The effects according to the spirit of the present disclosure are not limited to the effects mentioned above, and other effects not mentioned may be clearly understood by those of ordinary skill in the art to which the present disclosure pertains from the following description.

The above describes and illustrates specific embodiments. However, the present disclosure is not limited to the specific embodiments described above, and a person skilled in the art to which the present disclosure pertains would be able to make various modifications without departing from the scope of the technical spirit of the present disclosure as set forth in the following claims.

## Claims

1. A display apparatus, comprising:
a cabinet;
a substrate coupled to the cabinet and comprising light-emitting diodes (LEDs) mounted thereon;
a reinforcing member disposed between the substrate and the cabinet and coupled to the substrate;
a magnet disposed between the reinforcing member and the cabinet, such that the substrate is coupled to the cabinet by magnetic attraction between the reinforcing member and the cabinet; and
a grounding member disposed between the substrate and the reinforcing member, the grounding member being configured to discharge electromagnetic noise generated from the substrate on which the LEDs are mounted through the substrate, the grounding member, the reinforcing member, the magnet, and the cabinet.

2. The display apparatus of claim 1, wherein
the grounding member is a substrate grounding member, and
wherein the display apparatus further comprises a cabinet grounding member disposed between the reinforcing member and the cabinet, the cabinet grounding member being configured to discharge the electromagnetic noise through the reinforcing member, the cabinet grounding member, and the cabinet.

3. The display apparatus of claim 2, wherein
the cabinet comprises:
a frame comprising a first frame and a second frame extending in different directions; and
a corner bracket coupling the first frame and the second frame, and
wherein the electromagnetic noise is discharged from the substrate grounding member through at least one of the reinforcing member, the magnet, or the cabinet grounding member, and the frame and the corner bracket.

4. The display apparatus of claim 1, further comprising:
a holder disposed between the substrate and the reinforcing member, the holder comprising a ground hole corresponding to the grounding member.

5. The display apparatus of claim 4, further comprising:
a ground sealing member disposed between the holder and the reinforcing member to seal between the grounding member and the ground hole.

6. The display apparatus of claim 4 or claim 5, further comprising:
a display connector electrically connected to the substrate;
a display connector hole in the holder to expose the display connector;
a waterproof rib in the holder to surround the display connector hole to prevent water from being introduced from an outside of the display connector hole into the display connector hole; and
a sealing member disposed inside the waterproof rib to seal between the display connector hole and the waterproof rib.

7. The display apparatus of claim 1, further comprising:
a circuit case coupled to the cabinet and including a circuit connector hole;
a circuit connector disposed in the circuit connector hole of the circuit case to transmit signals to the substrate; and
a ground rib protruding from an edge forming the circuit connector hole of the circuit case.

8. The display apparatus of claim 7, wherein
the ground rib protrudes toward the substrate when the substrate is coupled to the cabinet.

9. The display apparatus of claim 7 or claim 8, wherein
the ground rib comprises:
an upper rib above the circuit connector; and
a lower rib below the circuit connector.

10. The display apparatus of claim 9, further comprising:
a display connector disposed on the substrate side and electrically connected to the circuit connector,
wherein the grounding member comprises:
an upper grounding member disposed on the display connector to contact the upper rib; and
a lower grounding member disposed on the display connector to contact the lower rib.

11. The display apparatus of claim 10, wherein
electromagnetic noise generated from the circuit connector and the display connector is configured to be discharged through the ground rib and the circuit case.

12. The display apparatus of claim 11, further comprising:
a connection bracket coupling the cabinet and the circuit case,
wherein electromagnetic noise generated from the substrate on which the LEDs is mounted, and electromagnetic noise generated from the circuit connector and the display connector are configured to be discharged through the ground rib, the circuit case, the connection bracket, and the cabinet.

13. The display apparatus of claim 12, wherein
the cabinet comprises:
a frame comprising a first frame and a second frame extending in different directions; and
a corner bracket coupling the first frame and the second frame, and
wherein electromagnetic noise generated from the substrate on which the LED is mounted and electromagnetic noise generated from the circuit connector and the display connector are configured to be discharged from the ground rib through the circuit case, the connection bracket, the frame, and the corner bracket.
